# DEMANDE DE BREVET EUROPEEN

(11) **EP 4 672 894 A1**
(43) Date de publication de la demande: **31.12.2025**
(21) Numéro de dépôt: 25180963.8
(22) Date de dépôt: 05.06.2025
(51) Int. Cl.: H10B 63/10, H10N 70/20

(54) **CIRCUIT MEMOIRE A BASE D'UN MATERIAU A CHANGEMENT DE PHASE**

(30) Priorité: 18.06.2024 FR 2406452
(71) Demandeur: STMicroelectronics International N.V., 1228 Plan-les-Ouates, Geneva (CH)
(72) Inventeur: BACQUIE, Valentin, 38000 GRENOBLE (FR); JEANNOT, Simon, 38000 GRENOBLE (FR); CABOUT, Thomas, 38000 GRENOBLE (FR); BOCCACCIO, Christian, 38190 BERNIN (FR); SANDRINI, Jury, 38000 GRENOBLE (FR)
(74) Mandataire: Cabinet Beaumont

(57) **Abrégé**

La présente description concerne un dispositif électronique comportant un circuit mémoire, le circuit comprenant :
- un substrat dans et sur lequel sont disposés des transistors de sélection ;
- un empilement d'interconnexion ;
- une pluralité d'éléments mémoires (M) disposés au-dessus de l'empilement d'interconnexion et organisés selon une matrice, formant des lignes et des colonnes,

chaque élément mémoire comprenant un empilement d'un élément résistif chauffant, d'une couche en un matériau à changement de phase (47) et d'une électrode supérieure (53), l'électrode supérieure étant commune aux éléments mémoires d'une même ligne,
dans lequel les éléments mémoires de deux lignes de bits successives sont séparés par une tranchée (58) comportant, dans une partie inférieure, un espace clos rempli d'un gaz ou de vide, la tranchée étant fermée par une couche isolante (59) s'étendant sur la face supérieure des éléments mémoires et dans une partie supérieure de la tranchée.

## Description

### Domaine technique

La présente description concerne de façon générale le domaine des dispositifs électroniques et vise plus particulièrement le domaine des puces électroniques comportant un circuit mémoire, à base d'un matériau à changement de phase, et leurs procédés de fabrication.

### Technique antérieure

Un matériau à changement de phase est un matériau ayant la capacité de changer d'état cristallin sous l'effet de la chaleur et plus particulièrement de commuter entre un état cristallin et un état amorphe, plus fortement résistif que l'état cristallin. Ce phénomène est utilisé pour définir deux états mémoires, par exemple 0 et 1, différenciés par la résistance mesurée à travers le matériau à changement de phase.

Il existe un besoin d'amélioration des puces électroniques comportant un circuit mémoire à base d'un matériau à changement de phase.

### Résumé de l'invention

Pour cela, un mode de réalisation prévoit un dispositif électronique comportant un circuit mémoire, le circuit mémoire comprenant :
- un substrat semiconducteur dans et sur lequel sont disposés des transistors de sélection ;
- un empilement d'interconnexion, disposé sur une face supérieure du substrat semiconducteur ;
- une pluralité d'éléments mémoires disposés au-dessus de l'empilement d'interconnexion et organisés selon une matrice, formant des lignes et des colonnes,
   chaque élément mémoire comprenant un empilement d'un élément résistif chauffant, d'une couche en un matériau à changement de phase et d'une électrode supérieure, l'électrode supérieure étant commune aux éléments mémoires d'une même ligne de façon à former des lignes de bits,
   dans lequel les éléments mémoires de deux lignes de bits successives sont séparés par une tranchée comportant, dans une partie inférieure, un espace clos rempli d'un gaz ou de vide, la tranchée étant fermée par une couche isolante s'étendant sur la face supérieure des éléments mémoires et dans une partie supérieure de la tranchée.

Selon un mode de réalisation, l'espace clos est rempli d'air.

Selon un mode de réalisation, la tranchée a une largeur inférieure à 150 nm, par exemple inférieure à 118 nm, par exemple inférieure à 100 nm.

Selon un mode de réalisation, la couche isolante est en nitrure de silicium.

Selon un mode de réalisation, la couche isolante a une épaisseur, sur la face supérieure de l'électrode supérieure, supérieure à 75 nm.

Selon un mode de réalisation, les éléments mémoires d'une même colonne sont des éléments mémoires d'une même ligne de mot, chaque transistor de sélection associé aux éléments mémoires d'une même ligne de mots étant relié à un via conducteur traversant l'empilement d'interconnexion.

Un autre mode de réalisation prévoit un procédé de fabrication, d'un dispositif électronique comportant un circuit mémoire comportant une pluralité d'éléments mémoires organisés selon une matrice, formant des lignes et des colonnes, chaque élément mémoire comprenant un empilement d'un élément résistif chauffant, d'une couche en un matériau à changement de phase et d'une électrode supérieure, l'électrode supérieure étant commune aux éléments mémoires d'une même ligne de façon à former des lignes de bits, dans lequel les éléments mémoires de deux lignes de bits successives sont séparés par une tranchée, le procédé comportant les étapes de :
a) formation de transistors de sélection dans et sur un substrat semiconducteur ;
b) formation d'un empilement d'interconnexion, disposé sur une face supérieure du substrat semiconducteur ;
c) formation des éléments mémoires au-dessus de l'empilement d'interconnexion ; et
d) formation d'une couche isolante s'étendant sur la face supérieure des éléments mémoires et dans une partie supérieure des tranchées de façon à fermer les tranchées et créer, dans une partie inférieure de chaque tranchée, un espace clos rempli d'un gaz.

Selon un mode de réalisation, la formation des éléments mémoires comprend les étapes de :
- formation des éléments résistifs chauffants ;
- dépôt de la couche en le matériau à changement de phase ;
- dépôt de l'électrode supérieure ; et
- gravure de la couche en le matériau à changement de phase et de l'électrode supérieure.

Selon un mode de réalisation, le procédé comporte, après l'étape c), une étape de dépôt d'une autre couche isolante sur la face supérieure et les flancs des éléments mémoires.

Selon un mode de réalisation, l'autre couche isolante est formée par une méthode de dépôt de couches minces atomiques.

Selon un mode de réalisation, la couche isolante est formée, à l'étape d), par une méthode de dépôt chimique en phase vapeur assisté par plasma.

Selon un mode de réalisation, la couche isolante est formée, à l'étape d), par une méthode de dépôt physique en phase vapeur.

Selon un mode de réalisation, le procédé comporte, après l'étape b), un étape de formation d'une pluralité d'ouvertures traversant l'entièreté de la hauteur de l'empilement d'interconnexion et une étape de remplissage de ces ouvertures en un matériau métallique de façon à former des vias conducteurs.

Un autre mode de réalisation prévoit un procédé d'utilisation d'un dispositif électronique tel que décrit ci-avant, le procédé comportant l'application d'un courant dans l'élément résistif chauffant de l'un des éléments mémoires, d'où il résulte un changement de phase cristalline de la couche en le matériau à changement de phase de l'élément mémoire, permettant le stockage d'un bit de données.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en perspective, partielle et schématique, d'un exemple d'un dispositif électronique selon un mode de réalisation ; et
la figure 2, la figure 3, la figure 4, la figure 5A et la figure 5B sont des vues, partielles et schématiques, illustrant des étapes d'un exemple de procédé de fabrication du dispositif électronique illustré en figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

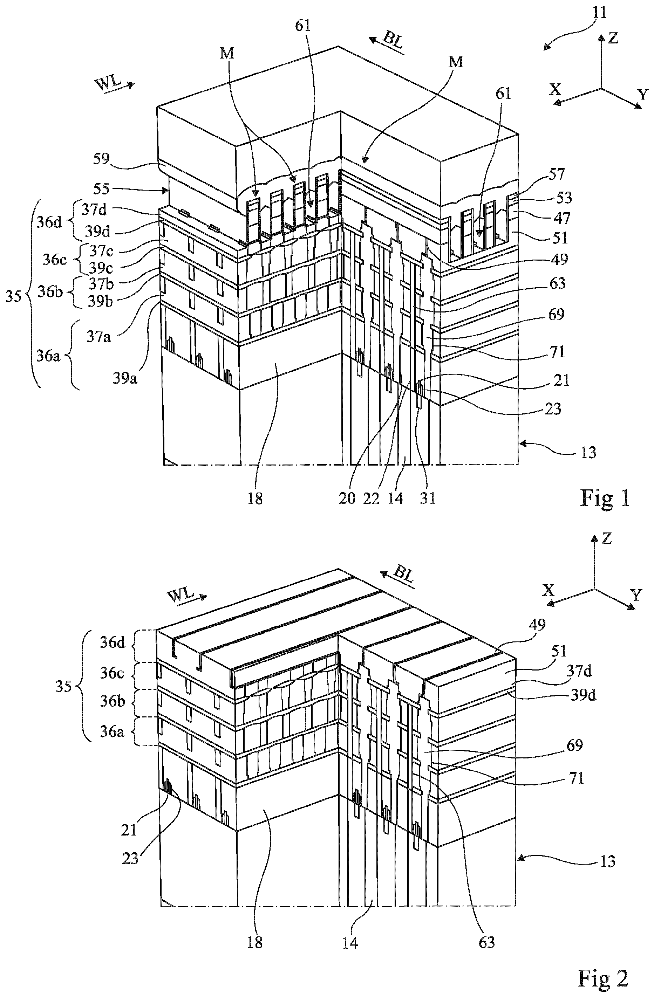

Dans la présente description, les modes de réalisation des figures 1 à 5B sont représentés dans l'espace selon un repère XYZ orthogonal direct, l'axe Z du repère étant orthogonal à la face supérieure du dispositif électronique.

La figure 1 est une vue en perspective, partielle et schématique, d'un exemple d'un dispositif électronique selon un mode de réalisation. Plus particulièrement, la figure 1 est une vue en perspective dans laquelle une partie du dispositif a été retirée de façon à dévoiler l'intérieur du dispositif et plus particulièrement dévoiler l'intérieur du dispositif selon les coupes des deux plans orthogonaux XZ et YZ.

Le dispositif 11 est par exemple une puce électronique.

Le dispositif 11 comprend un substrat semiconducteur 13. A titre d'exemple, le substrat 13 est en silicium ou à base de silicium.

Le substrat 13 comprend, par exemple, une couche semiconductrice, non représentée, dopée d'un premier type de conductivité, par exemple du type N, par exemple dopée d'atomes d'arsenic ou de phosphore. La couche dopée du type N repose par exemple sur, et est par exemple en contact avec, une autre couche semiconductrice du substrat 13 dopée d'un deuxième type de conductivité, opposé au premier type de conductivité, par exemple du type P, par exemple dopée d'atomes de bore.

A titre d'exemple, le substrat 13 comprend une autre couche semiconductrice, non représentée, affleurant sa face supérieure et reposant par exemple sur la couche dopée du type N. La couche semiconductrice supérieure est par exemple une couche formée par épitaxie à partir de la face supérieure de la couche dopée du type N. La couche semiconductrice supérieure est, par exemple en silicium, par exemple en silicium monocristallin. La couche semiconductrice supérieure comprend, par exemple, une pluralité de régions de deux types de conductivité opposées, par exemple une pluralité de régions du type P et une pluralité du type N, s'étendant longitudinalement sous forme de lignes dans une première direction. A titre d'exemple, les régions de la couche semiconductrice supérieure s'étendent dans la direction de l'axe X. Le substrat 13 comprend ainsi, au niveau de sa face supérieure, des lignes comprenant une alternance de régions du type P et de régions du type N s'étendant dans la direction de l'axe X.

A titre d'exemple, le dispositif comprend une pluralité de transistors formés dans et sur le substrat 13. Chaque transistor comprend, par exemple, une unique région du type N et une unique région du type P.

A titre d'exemple, les régions du type P et du type N d'un même transistor sont séparées et sont par exemple isolées électriquement par une tranchée isolante 31. Les tranchées isolantes 31 sont par exemple des tranchées d'isolation très peu profondes (SSTI, de l'anglais "Super Shallow Trench Isolation"). Les tranchées 31 s'étendant longitudinalement dans la direction de l'axe X.

Les tranchées d'isolation 31 s'étendent par exemple, à partir de la face supérieure du substrat 13, dans le substrat 13. Les tranchées 31 s'étendent de préférence dans une partie de la couche semiconductrice supérieure et dans la couche du type N sans atteindre la couche du type P. Les tranchées d'isolation 31 sont par exemple remplies d'un matériau diélectrique, par exemple d'oxyde de silicium. La profondeur des tranchées 31 est par exemple comprise entre 20 nm et 40 nm.

Chaque tranchée 31 est par exemple surmontée par un motif de grille 21 (en anglais "dummy gate") disposé sur la face supérieure du substrat 13, par exemple s'étendant longitudinalement dans la direction de l'axe X. Les motifs de grille 21 s'étendent par exemple sur toute la longueur des tranchées 31. Chaque motif de grille 21 est, par exemple, en un matériau semiconducteur, par exemple en silicium polycristallin. A titre d'exemple, les flancs verticaux de chaque motif de grille 21 sont recouverts par des espaceurs 23. Les espaceurs 23 sont par exemple en un matériau diélectrique, par exemple en un nitrure.

Les transistors sont par exemple séparés les uns des autres et sont par exemple isolés électriquement par des tranchées isolantes 14, ou tranchées d'isolation 14. Les tranchées isolantes 14 sont par exemple des tranchées d'isolation peu profondes (STI, de l'anglais "Shallow Trench Isolation"). Les tranchées 14 s'étendent longitudinalement dans la direction de l'axe X. A titre d'exemple, les tranchées 14 sont par exemple séparées par un ensemble formé par une tranchée 31 et un motif de grille 21.

Les tranchées d'isolation 14 s'étendent par exemple, à partir de la face supérieure du substrat 13, dans le substrat 13. Les tranchées 14 s'étendent de préférence dans une partie de la couche semiconductrice supérieure du substrat 13, dans la couche du type N et dans une partie de la couche du type P. Les tranchées d'isolation 14 sont par exemple remplies d'un matériau diélectrique, par exemple d'oxyde de silicium. A titre d'exemple, les tranchées 14 sont plus profondes que les tranchées 31. La profondeur des tranchées 14 est par exemple comprise entre 250 nm et 400 nm.

Les transistors sont par exemple agencés en matrice comprenant des lignes et des colonnes.

Chaque transistor est compris dans une cellule mémoire élémentaire. Chaque cellule mémoire comporte en outre un élément mémoire M, formé de préférence au moins partiellement en regard dudit transistor, par exemple en regard de la région du type P dudit transistor. Les régions du type N, à la différence des régions du type P, ne sont par exemple pas surmontées d'éléments mémoires M. A titre d'exemple, au sein de chaque cellule mémoire, le transistor est un transistor de sélection de l'élément mémoire M.

Les éléments mémoires M sont organisés, en vue de dessus, selon une matrice de lignes et de colonnes. On parle respectivement de lignes de mots (wordlines) s'étendant dans la direction de l'axe Y et de lignes de bits (bitlines), s'étendant dans la direction de l'axe X. A titre d'exemple, chaque élément mémoire M est situé à l'intersection d'une ligne de bits et d'une ligne de mots. A titre d'exemple, les éléments mémoires M dans le plan XZ sont des éléments mémoires M d'une même ligne de mots WL alors que les éléments mémoires dans le plan YZ sont des éléments mémoires d'une même ligne de bits BL.

Le dispositif 11 comprend par exemple une couche isolante 18 recouvrant la face supérieure du substrat semiconducteur 13 et plus précisément la face supérieure de la couche semiconductrice du substrat 13. La couche isolante 18 est par exemple en contact avec la face supérieure de la couche semiconductrice supérieure du substrat 13. La couche isolante 18 recouvre par exemple l'ensemble de la face supérieure de la couche semiconductrice supérieure du substrat 13. La couche isolante 18 a par exemple une épaisseur comprise entre 80 nm et 300 nm, par exemple comprise entre 120 nm et 200 nm.

La couche 18 est par exemple traversée par des vias 20 et 22. Les vias 20 et 22 sont par exemple en contact, par leurs faces inférieures, avec la face supérieure de la couche semiconductrice de sorte que chaque région du type N et P soit surmontée par un via 20 ou 22. Les vias 20 et 22 s'étendent par exemple sur toute la hauteur de la couche 18. Les vias 20 et 22 s'étendent ainsi de la face supérieure de la couche 18 à la face inférieure de la couche 18. Les vias 20 et 22 sont par exemple en un matériau conducteur, par exemple en tungstène.

Le dispositif comprend un empilement d'interconnexion 35, recouvrant par exemple la couche 18. Dans cet exemple, l'empilement d'interconnexion 35 est formé entre le substrat 13 et les éléments mémoires M. L'empilement d'interconnexion 35 est par exemple formé sur la face supérieure de la couche isolante 18 et recouvre par exemple toute la surface de la couche isolante 18.

L'empilement d'interconnexion 35 est par exemple formé d'une succession de niveaux 36, chaque niveau 36 comportant une couche isolante 37 et une couche isolante 39. L'empilement d'interconnexion 35 comprend par exemple un niveau 36a, comprenant une couche isolante 39a formée sur et en contact avec la face supérieure de la couche isolante 18. L'empilement d'interconnexion 35 comprend en outre dans le niveau 36a, une couche isolante 37a formée sur la couche isolante 39a. La couche isolante 37a est par exemple formée sur toute la surface de la couche isolante 39a. A titre d'exemple, la couche isolante 37a est en contact, par sa face inférieure, avec la face supérieure de la couche isolante 39a.

L'empilement d'interconnexion 35 peut en outre comprendre des niveaux supplémentaires formés sur le niveau 36a, c'est-à-dire sur et en contact avec la couche isolante 37a. En figure 1, l'empilement d'interconnexion 35 comprend trois niveaux supplémentaires 36b, 36c et 36d par exemple formés respectivement des couches 37b et 39b, des couches 37c et 39c et des couches 37d et 39d. En pratique, le nombre de niveaux dans l'empilement d'interconnexion 35 peut être différent de quatre, par exemple supérieur à quatre.

A titre d'exemple, l'empilement d'interconnexion 35 a une épaisseur comprise entre 300 nm et 800 nm, par exemple comprise entre 400 nm et 700 nm, par exemple de l'ordre de 500 nm.

A titre d'exemple, les couches isolantes 18 et 37 sont en un matériau de faible constante diélectrique, par exemple en un matériau ayant une constante diélectrique (correspondant à la permittivité dudit matériau par rapport à la permittivité du vide), inférieure à 5, par exemple inférieure à 4. Les couches isolantes 37 sont par exemple en oxycarbure de silicium (SiOC), en oxycarbure de silicium poreux, en SiOCH ou en SiOCH poreux. A titre d'exemple, les couches isolantes 39 sont en oxyde de faible permittivité, dits "low k" ou "ultra low k".

Selon le mode de réalisation illustré en figure 1, chaque niveau 36 comprend des vias 69 conducteurs et des pistes conductrices 71, les pistes 71 s'étendant dans la couche 39 par exemple à partir la face supérieure de la couche 39, affleurant ainsi la face supérieure de la couche 39. De préférence, les pistes 71 d'un niveau 36 s'étendent exclusivement dans la couche 39 dudit niveau 36. Les vias 69 d'un niveau de l'empilement 35 s'étendent à travers la couche 39 et à travers la couche 37 de ce même niveau 36. Plus précisément, les vias 69 d'un niveau de l'empilement 35 s'étendent de la face inférieure d'une piste 71 du même niveau à la face inférieure de la couche 37 ou à la face supérieure d'un via 20 ou 22 traversant la couche 18. A titre d'exemple, l'élément chauffant 49 repose et est en contact, par sa face inférieure, avec la face supérieure du via 69 traversant la couche 39 du plus haut niveau 36 de l'empilement 35.

Les vias et pistes conductrices 71 et 69 sont par exemple en un matériau métallique, par exemple en tungstène.

En variante, les vias 69 et pistes 71 en vis-à-vis d'une même cellule mémoire M peuvent être remplacés par un unique via conducteur traversant toute l'épaisseur de l'empilement d'interconnexion 35. A titre d'exemple, un unique via traverse l'ensemble des couches isolantes 39 et 37 de l'empilement d'interconnexion 35. Dans cette variante, chaque via unique est en contact, par sa face supérieure, avec la face inférieure de l'élément chauffant 49 de la cellule mémoire M. En outre, dans cette variante, chaque via unique est par exemple en contact, par sa face inférieure, avec un autre via conducteur 22, lui-même en contact avec la face supérieure du substrat 13. En outre, dans cette variante, les parois latérales du via unique sont par exemple planes. Les vias uniques ne comprennent par exemple pas de paliers. Dans cette variante, les vias uniques ont, par exemple, des dimensions latérales sensiblement constantes, par exemple une largeur, prise dans les plans YZ et XZ de la figure 1, comprise entre 40 nm et 100 nm, par exemple de l'ordre de 70 nm. Dans cette variante, les vias uniques sont par exemple réalisés par formation d'ouvertures dans l'empilement d'interconnexion 35 débouchant sur la face supérieure des vias 22 puis par dépôt d'une couche en le matériau des vias sur la face supérieure de la structure. Lors de cette étape, le matériau des vias uniques vient remplir intégralement les ouvertures formées dans l'empilement 35 lors d'une seule et même étape. A l'issue de l'étape de dépôt du matériau des vias uniques, une étape de polissage peut être prévue de façon à retirer l'excès du matériau déposé sur la face supérieure de la structure. Les vias uniques sont par exemple en un matériau métallique, par exemple en tungstène.

Cette variante permet avantageusement de s'affranchir des contraintes de dimensionnement des niveaux de métaux pour l'intégration des cellules PCM, la surface des vias uniques pouvant être inférieure à la surface d'une piste à la surface de l'empilement d'interconnexion 35.

Cette variante permet de plus avantageusement de réduire la résistance électrique du substrat 13 jusqu'à l'élément chauffant 49 en supprimant les interfaces multiples entre des vias 69 et des pistes 71.

A titre d'exemple, chaque élément mémoire M est connecté électriquement au transistor de sélection auquel il est associé par l'intermédiaire d'un via conducteur 63 traversant, par exemple, une partie seulement niveaux 36 de l'empilement d'interconnexion 35. A titre d'exemple, le via 63 traverse l'ensemble des niveaux 36 de l'empilement d'interconnexion 35 à l'exception, par exemple du niveau supérieur de l'empilement 35. Dans le mode de réalisation de la figure 1, les vias 63 traversent alors les niveaux 36a, 36b et 36c sans traverser le niveau 36d de l'empilement 35. Ici, les vias s'étendent alors de la face inférieure de la couche 39a à la face supérieure de la couche 37c.

Le via 63 est par exemple en contact, par sa face inférieure, avec un via conducteur 22, lui-même en contact avec la face supérieure de la région du type P du transistor associé à l'élément mémoire M.

Le via conducteur 63 est par exemple en un matériau métallique. Le via conducteur 63 est par exemple en cuivre. En variante, le via conducteur 63 est en cobalt ou en tungstène.

Un avantage de former les éléments mémoires M au dessus de l'empilement 35 est qu'il permet de s'affranchir des risques de contamination de la couche à changement de phase 47 engendrés par la formation de l'empilement 35 et des différents niveaux métalliques 36.

Un avantage de contrôler des lignes de mots par l'intermédiaire des vias 63 est que cela permet de s'affranchir des contraintes de dimensionnement des niveaux de métaux pour l'intégration des éléments à changement de phase, et ainsi rapprocher les lignes de mots des éléments mémoires M, la largeur des vias 63 pouvant être inférieure à la largeur d'une piste conductrice.

Les éléments mémoires M sont, dans le mode de réalisation de la figure 1, formés sur la face supérieure de l'empilement 35.

Les éléments mémoires M sont des éléments mémoires à changement de phase. Chaque élément comprend une couche 47 en un matériau à changement de phase, par exemple un matériau chalcogènure, par exemple un alliage de germanium, antimoine et tellure (GeSbTe) dit GST. La couche 47 a, par exemple, une épaisseur comprise entre 30 nm et 100 nm, par exemple de l'ordre de 50 nm. Les éléments mémoires M d'une même ligne de bits comprennent par exemple une couche 47 commune. Ainsi, le dispositif 11 comprend par exemple autant de couches 47 que de lignes de bits. Chaque couche 47 s'étend ainsi dans la direction des lignes de bits.

Dans chaque élément mémoire M, le matériau à changement de phase est contrôlé par l'élément résistif métallique chauffant 49 situé sous le matériau à changement de phase. L'élément 49 est par exemple en contact, par sa face supérieure, avec la face inférieure de la couche 47. L'élément 49 est par exemple entouré latéralement d'une couche en un isolant thermique 51. Par exemple, chaque élément 49 a une forme de "L" dans le plan de coupe YZ. A titre d'exemple, l'élément 49 est en nitrure de tantale ou en nitrure de titane silicium. A titre d'exemple, la couche 51 est en carbonitrure de silicium. A titre d'exemple, l'élément chauffant 49 a, par exemple, une épaisseur comprise entre 30 nm et 100 nm, par exemple de l'ordre de 60 nm.

La couche 47 est surmontée par une couche 53, par exemple en un matériau conducteur, par exemple en un matériau métallique. Plus précisément, la face supérieure de chaque couche 47 est par exemple au moins partiellement recouverte, par exemple entièrement recouverte, par une couche 53. Chaque couche 53 s'étend de préférence, dans la direction des lignes de bits, sur toute la longueur de la couche 47. La couche 53 est par exemple en nitrure de titane. A titre d'exemple, la couche 53 a une épaisseur comprise entre 10 nm et 50 nm, par exemple de l'ordre de 20 nm.

A titre d'exemple, dans chaque élément mémoire M, l'élément métallique 49 et la couche 53 forment respectivement une électrode inférieure et une électrode supérieure de l'élément mémoire M, et plus précisément des électrodes de l'élément résistif à résistance variable formé par la couche 47 en le matériau à changement de phase. Les éléments mémoires M d'une même ligne de bits sont surmontés d'une même couche 53. En d'autres termes, les électrodes supérieures 53 des éléments mémoires M d'une même ligne de bits sont interconnectées.

La couche 53 est, par exemple surmontée par une couche 57, par exemple en un matériau isolant, par exemple en un matériau diélectrique. La couche d'isolation 57 est par exemple en un nitrure, par exemple en nitrure de silicium. La face supérieure de chaque couche 53 est par exemple au moins partiellement recouverte, par exemple entièrement recouverte, par une couche 57. Chaque couche 57 s'étend de préférence, dans la direction des lignes de bits, sur toute la longueur de la couche 53. A titre d'exemple, la couche 57 a une épaisseur comprise entre 10 nm et 50 nm, par exemple de l'ordre de 25 nm.

Chaque élément mémoire M est par exemple recouvert par une couche d'isolation 55 protégeant, par exemple la couche 47 en le matériau à changement de phase de l'oxydation. A titre d'exemple, la couche 55 recouvre la face supérieure de la couche 57 et les flancs des couches 53, 57, 47 et 51. La couche 55 est par exemple en un matériau diélectrique. La couche d'isolation 55 est par exemple en un nitrure, par exemple en nitrure de silicium.

Les éléments mémoires M de lignes de bits voisines sont isolés les unes des autres par un espace clos 61 surmonté d'une couche isolante 59. L'espace clos 61 est rempli d'un gaz ou de vide. A titre d'exemple, l'espace clos 61 est rempli d'air. En variante, l'espace clos 61 est rempli d'un gaz neutre. La couche isolante 59 est, par exemple, en un matériau diélectrique, par exemple en un nitrure, par exemple en nitrure de silicium. La couche 59 recouvre la face supérieure des éléments mémoires M et s'étend dans une partie supérieure seulement de la profondeur des tranchées séparant les lignes de bits des éléments mémoires M. L'espace clos 61 est par exemple délimité latéralement par la couche 55 recouvrant deux éléments mémoires M voisins. L'espace clos 61 est de plus délimité par la face supérieure de la couche 37d ou le cas échéant la couche 55 qui recouvre la couche 37d. En outre, l'espace clos 61 est délimité par la face inférieure de la couche 59. Chaque espace clos 61 s'étendent entre deux lignes de bits, par exemple sur toute la longueur des lignes de bits, par exemple dans la direction de l'axe Y.

Afin de pouvoir appliquer des potentiels aux lignes de mots des éléments mémoires M, le via 63 et les vias 22 se prolongent par exemple longitudinalement dans la direction de l'axe X en dehors du dispositif illustré en figure 1. Afin de pouvoir appliquer des potentiels aux lignes de bits des éléments mémoires M, la couche 53 qui correspond à l'électrode supérieure se prolonge par exemple longitudinalement dans la direction de l'axe Y en dehors du dispositif illustré en figure 1.

La figure 2, la figure 3, la figure 4, la figure 5A et la figure 5B sont des vues, partielles et schématiques, illustrant des étapes d'un exemple de procédé de fabrication du dispositif électronique illustré en figure 1.

La figure 2 illustre une structure de départ et plus particulièrement une vue en perspective de la structure de départ.

A titre d'exemple, la structure de départ comporte le substrat semiconducteur 13 sur lequel l'empilement d'interconnexion 35 a été formé. La structure comporte en outre, la couche 51 dans laquelle sont formés les éléments résistifs chauffants 49.

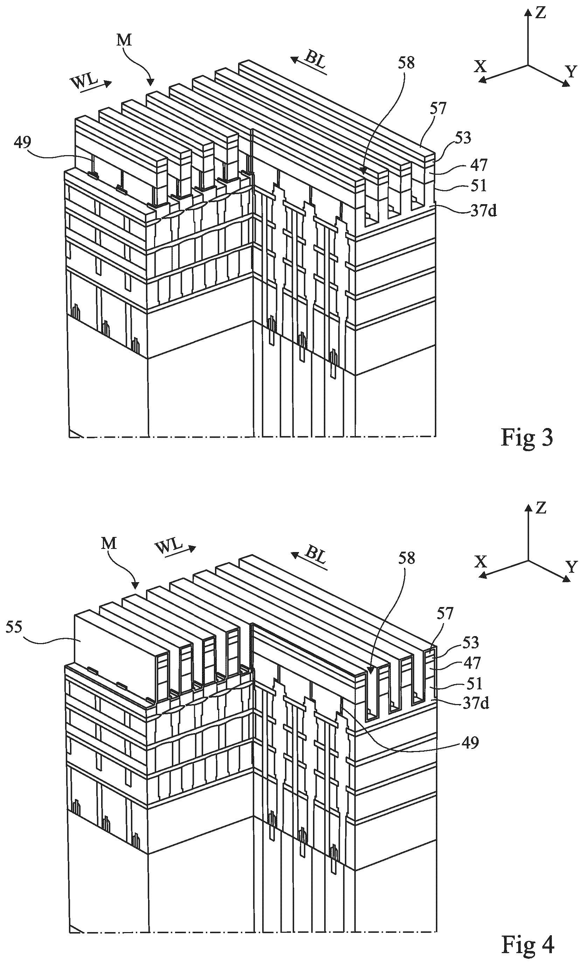

La figure 3 illustre une structure obtenue à l'issue d'une étape de formation des éléments mémoires M sur la face supérieure de la structure illustrée en figure 2. Plus particulièrement, la figure 3 illustre une vue en perspective de la structure.

Lors de cette étape, les couches 47, 53 et 57 sont, par exemple, déposées successivement sur la face supérieure de la structure illustrée en figure 2. Lors de cette étape, les couches 47, 53 et 57 sont par exemple déposées pleine plaque de façon à recouvrir toute la surface de la couche 51.

A l'issue du dépôt des couches 47, 53 et 57, on vient par exemple les graver de façon à former, dans ces couches, des tranchées 58 délimitant les lignes de bits dans l'empilement des couches susmentionnées. A titre d'exemple, lors de cette étape, la couche 51 et l'élément résistif chauffant 49 sont également gravés.

La figure 4 illustre une structure obtenue à l'issue d'une étape de dépôt de la couche 55 sur la face supérieure de la structure illustrée en figure 3. Plus particulièrement, la figure 4 illustre une vue en perspective de la structure.

Lors de cette étape, la couche 55 est par exemple déposée sur l'ensemble de la face supérieure de la structure illustrée en figure 3 et plus précisément sur la face supérieure de la couche 57, sur la face supérieure de la couche 37d, dans les tranchées 58, et sur les flancs des couches 57, 53, 47 et 51. A titre d'exemple, la couche 55 est déposée de façon conforme, c'est-à-dire avec une épaisseur constante. A titre d'exemple, la couche 55 a une épaisseur comprise entre 1 nm et 70 nm, par exemple comprise entre 20 nm et 40 nm, par exemple de l'ordre de 33 nm.

A titre d'exemple, la couche 55 est déposée par une méthode de dépôt de couches minces atomiques (ALD, de l'anglais "Atomic Layer Deposition").

A l'issue de cette étape, la couche 55 est par exemple retirée sur la face supérieure de la couche 37d, au fond des tranchées 58, de façon à n'être conservée que sur les flancs des couches 57, 53, 47 et 51 et sur la face supérieure de la couche 57.

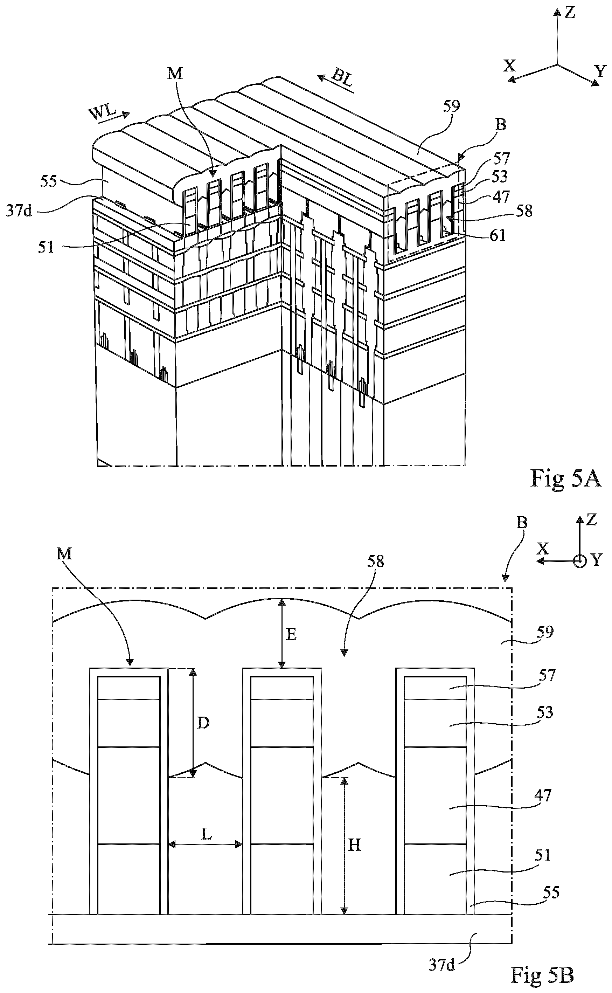

Les figures 5A et 5B illustrent une structure obtenue à l'issue d'une étape de dépôt de la couche 59 sur la face supérieure de la structure illustrée en figure 4. Plus particulièrement, la figure 5B correspond à un agrandissement de la région B de la figure 5A, la figure 5A correspondant à une vue en perspective de la structure et la figure 5B correspondant à une vue en coupe de la structure.

Lors de cette étape, on dépose la couche 59 au dessus des tranchées 58 par un procédé de dépôt non conforme de façon à former un bouchon. L'air ou le gaz ambiant (dans l'enceinte de traitement lors de cette étape) est alors piégé dans les tranchées 58 en formant l'espace clos 61.

Le gaz compris dans l'espace clos 61 est par exemple un gaz neutre ou de l'air. A titre d'exemple, le gaz est du diazote ou de l'argon. L'espace clos 61 a, par exemple une hauteur H comprise entre 50 nm et 170 nm, par exemple de l'ordre de 90 nm.

Les lignes de bits sont de préférences toutes espacées régulièrement, les tranchées 58 ayant donc toutes une largeur L sensiblement identique.

A titre d'exemple, la largeur L des tranchées 58 est inférieure à 150 nm, par exemple inférieure à 118 nm, par exemple inférieure à 100 nm.

Le dépôt de la couche 59 est par exemple réalisé par dépôt successif de plusieurs sous-couches, par exemple identiques. A titre d'exemple, le dépôt de la couche 59 est réalisé par dépôt successif de trois sous-couches. En variante, le dépôt de la couche 59 est réalisé par dépôt successif de plus que trois sous-couches.

Les sous-couches de la couche 59 sont par exemple déposées par une méthode de dépôt moins conforme que le dépôt ALD. A titre d'exemple, les sous-couches de la couche 59 ne sont pas déposées par ALD. A titre d'exemple, les sous-couches de la couche 59 sont déposées par une méthode de dépôt chimique en phase vapeur (CVD, de l'anglais " Chemical Vapor Deposition"), par exemple par une méthode de dépôt chimique en phase vapeur assisté par plasma (PECVD, de l'anglais "Plasma Enhanced Chemical Vapor Deposition"). En variante, la couche 59 est déposée par une méthode de dépôt physique en phase vapeur (PVD, de l'anglais "Physical Vapor Deposition").

A titre d'exemple, la couche 59 s'introduit dans la tranchée 58 sur une profondeur ou distance D le long des parois des lignes de bits. La profondeur D est, par exemple, comprise entre 10 nm et 100 nm par exemple entre 30 nm et 60 nm.

Afin que la couche 59 puisse former un bouchon au dessus et dans une partie supérieure de la tranchée 58, la couche 59 est déposée avec une épaisseur E, à partir de la face supérieure de la couche 55, supérieure ou égale à la moitié de la largeur L. L'épaisseur E de la couche 59 est, par exemple supérieure ou égale à 50 µm, par exemple supérieure ou égale à 59 nm, par exemple supérieure ou égale à 75 nm.

Un avantage du présent mode de réalisation est que l'introduction de gaz dans une tranchée permet de diminuer la permittivité relative des tranchées séparant deux lignes de bits vis-à-vis de tranchées comblées d'un matériau diélectrique, par exemple du nitrure de silicium.

Un autre avantage du présent mode de réalisation est qu'il permet de limiter la conductivité thermique entre les lignes de bits. Cela permet de limiter la perturbation thermique d'éléments mémoires M, en cours de programmation, envers les éléments voisins.

Encore un autre avantage du présent mode de réalisation est qu'il permet de rapprocher davantage les lignes de bits et ainsi réduire la taille des circuits mémoires.

De nombreuses applications sont susceptibles de tirer profit des avantages procurés par le dispositif électronique 11, dispositif électronique 11 pouvant ainsi être intégré dans divers types de dispositifs.

À titre d'exemple, le dispositif électronique 11 peut être intégré dans un dispositif destiné à l'industrie automobile. L'électrification des véhicules automobiles cause une forte augmentation du nombre de composants électroniques présents dans les véhicules. Le dispositif comprend par exemple des thyristors, des redresseurs, des diodes de suppression de tensions transitoires, des modules, etc. destinés à être incorporés dans lesdits véhicules. Par ailleurs, l'aide à la conduite et l'automatisation de la conduite sont à l'origine d'une augmentation du nombre de composants électroniques dans les véhicules. Le dispositif comprend par exemple des diodes de suppression de tensions transitoires, une protection contre les décharges électrostatiques et des filtres de mode commun permettant de protéger le dispositif contre des risques électriques.

À titre d'exemple, le dispositif électronique 11 peut être intégré dans un dispositif destiné à l'industrie. En particulier, le dispositif est par exemple utilisé pour le développement des énergies vertes ou pour l'électrification d'infrastructures, par exemple pour des bornes de recharge ou pour la collecte d'énergie solaire. Le dispositif peut également être utilisé dans le domaine de l'internet des objets ou dans le domaine des maisons connectées. Le dispositif est par exemple destiné à être mis en œuvre dans des circuits d'alimentation en énergie électrique d'équipements, comprenant par exemple des thyristors 800 V ou 1 200 V, des diodes 1 200 V ultrarapides et au carbure de silicium, des diodes de suppression de tensions transitoires et des protections contre les décharges électrostatiques. Le dispositif peut également être utilisé pour la mise en œuvre de systèmes d'informatique dans le nuage, de réseaux de communication radiofréquence 5G, de centres de données et de serveurs. Le dispositif comprend par exemple des matériaux à large bande interdite.

À titre d'exemple, le dispositif électronique 11 peut être intégré dans un dispositif destiné à être utilisé dans l'électronique personnelle, par exemple dans le but d'augmenter un volume d'informations échangées par communication radiofréquence, dans des systèmes de communication 5G, ou plus généralement dans tout dispositif connecté. Le dispositif est par exemple un téléphone mobile, ou smartphone, ou fait partie d'un réseau de l'internet des objets. Le dispositif est par exemple connecté par 5G, par WiFi ou par communication large bande. Le dispositif comprend par exemple des interfaces à haut débit, par exemple avec un filtrage avancé et une protection contre les décharges électrostatiques.

À titre d'exemple, le dispositif électronique 11 peut être intégré dans un dispositif destiné à être utilisé dans des équipements de communication, ou dans des ordinateurs et des périphériques. Le dispositif est par exemple utilisé dans des infrastructures 5G et des centres de données dédiés. Le dispositif comprend par exemple des diodes en carbure de silicium, des transistors de puissance Schottky, des protections contre les décharges électrostatiques et des diodes de suppression des tensions transitoires. Le dispositif peut également être utilisé dans des satellites comprenant par exemple des dispositifs passifs intégrés pour des applications radiofréquence.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

De plus, bien que l'on ait décrit des modes de réalisation dans lesquels les éléments mémoires M sont recouverts d'une couche 55, on peut prévoir d'omettre cette couche, la couche 59 est alors déposée directement sur la face supérieure de la couche 57 et s'étend le long des flancs latéraux des éléments mémoires M. Afin de préserver la stabilité chimique des couches 51, 47, 53 et 57, et notamment les préserver de l'oxydation, la couche 59 s'étend dans cette variante sur l'entièreté des flancs latéraux des éléments mémoires M jusqu'à atteindre la face supérieure de la couche 37d. Dans cette variante, la couche 59 a une épaisseur supérieure ou égale à 2 nm.

Enfin, la mise en oeuvre pratique des modes de réalisation et variantes décrits est à la portée de la personne du métier à partir des indications fonctionnelles données ci-dessus.

## Revendications

1. Dispositif électronique (11) comportant un circuit mémoire, le circuit mémoire comprenant :
- un substrat semiconducteur (13) dans et sur lequel sont disposés des transistors de sélection ;
- un empilement d'interconnexion (35), disposé sur une face supérieure du substrat semiconducteur ;
- une pluralité d'éléments mémoires (M) disposés au-dessus de l'empilement d'interconnexion et organisés selon une matrice, formant des lignes et des colonnes,
chaque élément mémoire (M) comprenant un empilement d'un élément résistif chauffant (49), d'une couche en un matériau à changement de phase (47) et d'une électrode supérieure (53), l'électrode supérieure (53) étant commune aux éléments mémoires d'une même ligne de façon à former des lignes de bits (BL),
dans lequel les éléments mémoires (M) de deux lignes de bits successives sont séparés par une tranchée (58) comportant, dans une partie inférieure, un espace clos (61) rempli d'un gaz ou de vide, la tranchée étant fermée par une couche isolante (59) s'étendant sur la face supérieure des éléments mémoires (M) et dans une partie supérieure de la tranchée (58).

2. Dispositif électronique selon la revendication 1, dans lequel l'espace clos (61) est rempli d'air.

3. Dispositif selon la revendication 1 ou 2, dans lequel la tranchée (58) a une largeur inférieure à 105 nm, par exemple inférieure à 118 nm, par exemple inférieure à 100 nm.

4. Dispositif selon l'une quelconque des revendications 1 à 3, dans lequel la couche isolante (59) est en nitrure de silicium.

5. Dispositif selon l'une quelconque des revendications 1 à 4, dans lequel la couche isolante (59) a une épaisseur, sur la face supérieure de l'électrode supérieure (53), supérieure à 75 nm.

6. Dispositif selon l'une quelconque des revendications dans lequel les éléments mémoires (M) d'une même colonne sont des éléments mémoires (M) d'une même ligne de mot (WL), chaque transistor de sélection associé aux éléments mémoires (M) d'une même ligne de mots étant relié à un via conducteur (63) traversant l'empilement d'interconnexion (35).

7. Dispositif selon l'une quelconque des revendications 1 à 6, dans lequel chaque élément mémoire (M) étant adapté à être relié électriquement à un transistor de sélection par l'intermédiaire d'un via conducteur unique traversant toute l'épaisseur de l'empilement d'interconnexion (35).

8. Procédé de fabrication, d'un dispositif électronique (11) comportant un circuit mémoire comportant une pluralité d'éléments mémoires organisés selon une matrice, formant des lignes et des colonnes, chaque élément mémoire (M) comprenant un empilement d'un élément résistif chauffant (49), d'une couche en un matériau à changement de phase (47) et d'une électrode supérieure (53), l'électrode supérieure (53) étant commune aux éléments mémoires d'une même ligne de façon à former des lignes de bits (BL), dans lequel les éléments mémoires (M) de deux lignes de bits successives sont séparés par une tranchée, le procédé comportant les étapes de :
a) formation de transistors de sélection dans et sur un substrat semiconducteur (13) ;
b) formation d'un empilement d'interconnexion (35), disposé sur une face supérieure du substrat semiconducteur ;
c) formation des éléments mémoires (M) au-dessus de l'empilement d'interconnexion ; et
d) formation d'une couche isolante (59) s'étendant sur la face supérieure des éléments mémoires (M) et dans une partie supérieure des tranchées (58) de façon à fermer les tranchées et créer, dans une partie inférieure de chaque tranchée, un espace clos (61) rempli d'un gaz.

9. Procédé selon la revendication 8, dans lequel la formation des éléments mémoires comprend les étapes de :
- formation des éléments résistifs chauffants (49) ;
- dépôt de la couche en le matériau à changement de phase (47) ;
- dépôt de l'électrode supérieure (53) ; et
- gravure de la couche en le matériau à changement de phase et de l'électrode supérieure (53).

10. Procédé selon la revendication 8 ou 9, comportant, après l'étape c), une étape de dépôt d'une autre couche isolante (55) sur la face supérieure et les flancs des éléments mémoires (M).

11. Procédé selon la revendication 10, dans lequel l'autre couche isolante est formée par une méthode de dépôt de couches minces atomiques.

12. Procédé selon l'une quelconque des revendications 8 à 11, dans lequel la couche isolante (59) est formée, à l'étape d), par une méthode de dépôt chimique en phase vapeur assisté par plasma.

13. Procédé selon l'une quelconque des revendications 8 à 11, dans lequel la couche isolante (59) est formée, à l'étape d), par une méthode de dépôt physique en phase vapeur.

14. Procédé selon l'une quelconque des revendications 8 à 13, comportant, après l'étape b), un étape de formation d'une pluralité d'ouvertures traversant l'entièreté de la hauteur de l'empilement d'interconnexion (35) et une étape de remplissage de ces ouvertures en un matériau métallique de façon à former des vias conducteurs (63).

15. Procédé d'utilisation d'un dispositif électronique (11) selon l'une quelconque des revendications 1 à 7, comportant l'application d'un courant dans l'élément résistif chauffant (49) de l'un des éléments mémoires (M), d'où il résulte un changement de phase cristalline de la couche en le matériau à changement de phase (47) de l'élément mémoire (M), permettant le stockage d'un bit de données.
